(19)

Europäisches Patentamt

European Patent Office

Office européen des brevets

(11) **EP 2 253 466 A1**

(12) **EUROPEAN PATENT APPLICATION**
published in accordance with Art. 153(4) EPC

(43) Date of publication:
**24.11.2010 Bulletin 2010/47**

(51) Int Cl.:
***B32B 27/00*** (2006.01)   ***G02B 5/30*** (2006.01)

(21) Application number: **09720364.0**

(22) Date of filing: **26.02.2009**

(86) International application number:
**PCT/JP2009/000845**

(87) International publication number:
**WO 2009/113258 (17.09.2009 Gazette 2009/38)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **09.03.2008 JP 2008058865**
**09.03.2008 JP 2008058866**
**09.03.2008 JP 2008058867**

(71) Applicant: **Mitsubishi Plastics, Inc.**
**Tokyo 103-0021 (JP)**

(72) Inventor: **HAYASHIZAKI, Keiichi**
**Maibara-shi**
**Shiga-ken 521-0234 (JP)**

(74) Representative: **Merkle, Gebhard**
**TER MEER STEINMEISTER & PARTNER GbR,**
**Patentanwälte**
**Mauerkircherstrasse 45**
**81679 München (DE)**

(54) **MOLD RELEASE FILM**

(57) The present invention provides a release film which can be peeled off with a light peel force and can exhibit an excellent retention force upon storage as well as an excellent resistance to atmospheric exposure and an excellent anti-migration property. The release film comprises a polyester film and a coating material applied onto at least one surface of the polyester film which comprises a curing type silicone as a main component, wherein the curing type silicone in the coating material comprises a vinyl group-containing polysiloxane chain in which a content of the vinyl group is not less than 3% in terms of siloxane units; and wherein a ratio of SiH to Vi (SiH/Vi) in the coating material is 2.5 to 7.

EP 2 253 466 A1

## Description

<u>TECHNICAL FIELD</u>

The present invention relates to a release film.

<u>BACKGROUND ART</u>

Release films using a polyester film as a base material have been used in extensive applications for production of components of liquid crystal polarizing plates or retardation (phase difference) plates, components of PDP, components of organic EL devices and components of various displays, as well as in various optical applications, because of excellent properties thereof. Among these applications, there is a rapid increase in production of release films for liquid crystal polarizing plates owing to recent remarkable progress of LCD markets. In addition, with the recent tendency toward low price of LCDs, there occurs a large demand for improvement in production yield of components of LCDs and achievement of high-speed production thereof in order to realize reduction in price of these respective components.

As to the demand for high-speed production, it has now been required to conduct even the step of attaching the polarizing plate to a liquid crystal panel at a higher speed. In order to shorten a takt time of attachment of the LCD polarizing plate to the liquid crystal panel, it is required to increase a peel velocity of a release film therefrom. At present, the peel velocity of the release film has been practically increased from conventional several m/min up to not less than 20 m/min. However, when the release film is peeled at such a high velocity as not less than 20 m/min, there tends to arise such a problem that the LCD polarizing plate undergoes undesirable displacement owing to the large peel force exceeding an absorption force on the fixed side of the polarizing plate. Once the above problem is caused, an automated production line of the polarizing plate must be interrupted, so that its productivity will be inevitably deteriorated. To solve the above problem, it might be considered that the absorption force on the fixed side of the polarizing plate is strengthened. However, this method has limitations since undesirable suction marks tend to remain on the polarizing plate.

Thus, it is required that the release film is peeled with a small force. On the other hand, during the process until just before the peeling step, it is required that the release film is firmly attached to an adhesive layer with a sufficient retention force. In particular, the release film tends to suffer from peeling or floating by subjecting the polarizing plate to cutting or blanking or by the difference in degree of elongation or contraction between the materials owing to change in temperature and humidity upon storage thereof, resulting in deteriorated productivity thereof.

In the conventional films, it has been difficult to fully satisfy both of light peel force upon high-speed peeling and relatively heavy peel force upon low-speed peeling which has a close relationship with its retention force. Also, even when the release film is modified in its design to accomplish these aims, it has been still unsatisfactory to attain excellent performances thereof owing to problems such as migration of components unfixed to a polymer and poor resistance to atmospheric exposure which tends to cause heavy peeling upon contact of a releasing surface of the film with atmospheric air.

  Patent Document 1: Japanese Patent Application Laid-Open (KOKAI) No. 2001-290141
  Patent Document 2: Japanese Patent Application Laid-Open (KOKAI) No. 2001-47580

<u>DISCLOSURE OF THE INVENTION</u>

<u>Problems to be Solved by the Invention</u>

The present invention has been accomplished to solve the above problems. An object of the present invention is to provide a release film which can be peeled off not only with a light peel force even at a high speed corresponding to a practical peel velocity and with a relatively heavy peel force at a low speed which has a close relationship with a retention force upon storage, and further can be less influenced by atmospheric exposure and can exhibit an excellent anti-migration property.

<u>Means for Solving Problems</u>

As a result of the present inventors' earnest study, it has been found that the above problems can be readily solved by the release film having a specific construction. The present invention has been attained on the basis of this finding. The present invention includes a group of inventions, and the aspects of the respective inventions are as follows.

That is, in a first aspect of the present invention, there is provided a release film comprising a polyester film and a coating material applied onto at least one surface of the polyester film which comprises a curing type silicone as a main component,

the curing type silicone in the coating material comprising a vinyl group-containing polysiloxane chain in which a content of the vinyl group is not less than 3% in terms of siloxane units; and
a ratio of SiH to Vi (SiH/Vi) in the coating material being 2.5 to 7.

In a second aspect of the present invention, there is provided a release film comprising a polyester film and a coating material applied onto at least one surface of the polyester film which comprises a curing type silicone as a main component,
the coating material comprising, as main components, a solvent type silicone comprising a vinyl group-containing polysiloxane chain in which a content of the vinyl group is not less than 3% in terms of siloxane units, and a solvent-free type silicone having a viscosity of not more than 1000 mPa·s and comprising a vinyl group-containing polysiloxane chain in which a content of the vinyl group is not less than 3% in terms of siloxane units; and
a ratio of SiH to Vi (SiH/Vi) in the coating material being 2.5 to 7.

In a third aspect of the present invention, there is provided a release film comprising a polyester film and a coating material applied onto at least one surface of the polyester film which comprises a curing type silicone as a main component,
the coating material comprising, as main components, a solvent type silicone comprising a vinyl group-containing polysiloxane chain in which a content of the vinyl group is not less than 3% in terms of siloxane units, a solvent-free type silicone having a viscosity of not more than 1000 mPa·s and comprising a vinyl group-containing polysiloxane chain in which a content of the vinyl group is not less than 3% in terms of siloxane units, and a reactive heavy-release modifier; and
a ratio of SiH to Vi (SiH/Vi) in the coating material being 2.5 to 7.

EFFECT OF THE INVENTION

The present invention provides a release film which can be peeled off with a light peel force, and can exhibit an excellent retention force, an excellent resistance to atmospheric exposure and an excellent anti-migration property, and therefore has an extremely high industrial value.

PREFERRED EMBODIMENTS FOR CARRYING OUT THE INVENTION

The present invention is described in detail below.
In the present invention, the polyester used in the polyester film may be in the form of either a homopolyester or a copolyester. As the homopolyester, there are preferably used those homopolyesters obtained by polycondensing an aromatic dicarboxylic acid with an aliphatic glycol. Examples of the aromatic dicarboxylic acid include terephthalic acid and 2-naphthalenedicarboxylic acid. Examples of the aliphatic glycol include ethylene glycol, diethylene glycol and 1,4-cyclohexane dimethanol. Typical examples of the polyester include polyethylene terephthalate (PET) and polyethylene-2,6-naphthalenedicaboxylate (PEN).

On the other hand, as the copolyester, there are preferably used those copolymers obtained by copolymerizing the third component in an amount of not more than 30 mol% with the above main components. The dicarboxylic acid component used in the copolyester may be one or more acids selected from isophthalic acid, phthalic acid, terephthalic acid, 2,6-naphthalenedicarboxylic acid, adipic acid, sebacic acid, oxycarboxylic acids (such as, for example, p-oxybenzoic acid). The glycol component used in the copolyester may be one or more glycols selected from ethylene glycol, diethylene glycol, propylene glycol, butanediol, 1,4-cyclohexane dimethanol and neopentyl glycol.

In any cases, the polyester as used in the present invention is intended to mean polyesters such as polyethylene terephthalate comprising an ethylene terephthalate unit in an amount of usually not less than 80 mol% and preferably not less than 90 mol%, and polyethylene-2,6-naphthalate comprising an ethylene-2,6-naphthalate unit in an amount of usually not less than 80 mol% and preferably not less than 90 mol%, etc.

In the polyester layer used in the present invention, particles are preferably blended therein for the purpose of imparting an easy-slip property thereto. The kinds of particles to be blended are not particularly limited as long as they are capable of imparting the easy-slip property to the polyester layer. Specific examples of the particles include particles of silica, calcium carbonate, magnesium carbonate, barium carbonate, calcium sulfate, calcium phosphate, magnesium phosphate, kaolin, aluminum oxide, titanium oxide, etc. In addition, as the particles, there may also be used heat-resistant organic particles as described in Japanese Patent Publication (KOKOKU) No. 59-5216, Japanese Patent Application Laid-Open (KOKAI) No. 59-217755, etc. Examples of the other organic particles usable herein include particles of thermosetting urea resins, thermosetting phenol resins, thermosetting epoxy resins and benzoguanamine resins. As the particles, there may be further used deposited particles obtained by precipitating and finely dispersing a part of metal compounds such as a catalyst during the process for production of the polyester.

On the other hand, the shape of the particles used is not particularly limited, and may be any of a spherical shape, a massive shape, a bar shape, a flat shape, etc. In addition, the hardness, specific gravity and color of the particles, etc., are not particularly limited. These particles may be used in combination of any two or more kinds thereof, if required.

The average particle diameter of the particles incorporated in the polyester film used in the present invention is preferably in the range of 0.1 to 5 $\mu$m, more preferably 0.5 to 3 $\mu$m and most preferably 0.5 to 2 $\mu$m. When the average particle diameter of the particles is less than 0.1 $\mu$m, the particles tend to be agglomerated together and have an insufficient dispersibility. On the other hand, when the average particle diameter of the particles is more than 5 $\mu$m, the resulting polyester film tends to have an excessively high surface roughness, so that there tends to arise such a problem that the release layer is hardly formed thereon in the subsequent step.

The content of the particles in the polyester is preferably in the range of 0.01 to 5% by weight and more preferably 0.01 to 3% by weight. When the content of the particles in the polyester is less than 0.01% by weight, the resulting film tends to be insufficient in easy-slip property. On the other hand, when the particles are added to the polyester in an amount of more than 5% by weight, the resulting film tends to be insufficient in surface smoothness.

Meanwhile, the polyester film used in the present invention may comprise, in addition to the above particles, conventionally known additives such as an antioxidant, a heat stabilizer, a lubricant, a dye and a pigment, unless the addition thereof adversely affects the aimed effects of the present invention.

As to the thickness of the polyester film constituting the release film of the present invention, the polyester film is preferably in the form of a thinner film in view of the costs. However, it is required that the film ensures a good surface flatness. In the case where the thickness of the polyester film constituting the release film is too small, the polyester film tends to be frequently deteriorated in surface flatness owing to occurrence of wrinkles, etc., when subjected to heat treatment for processing the film. In addition, when any undesirable force is applied to the polarizing plate obtained by processing the film, such a thin polyester film may fail to exhibit a sufficient function for protecting an adhesive.

From the above viewpoints, the thickness of the polyester film constituting the release film of the present invention is preferably 12 to 125 $\mu$m and more preferably 25 to 75 $\mu$m.

Next, an example of a method for production of the polyester film used in the present invention is more specifically described below, although not particularly limited thereto. That is, there is preferably used the method in which the above-mentioned polyester is used as the raw material and extruded from a die to obtain a molten sheet, and then the molten sheet is cooled and solidified on a cooling roll to obtain an unstretched sheet. In this case, in order to improve a surface flatness of the sheet, it is required to enhance adhesion between the sheet and a rotary cooling drum. For this purpose, an electrostatic pinning method and/or a liquid coating pinning method are preferably used. Next, the thus obtained unstretched sheet is biaxially stretched. When subjecting the sheet to biaxial stretching, the unstretched sheet is first stretched in one direction thereof using a roll or a tenter-type stretching machine. The stretching temperature is usually 70 to 120°C and preferably 80 to 110°C, and the stretching ratio is usually 2.5 to 7 times and preferably 3.0 to 6 times. Then, the thus stretched sheet is stretched in the direction perpendicular to that of the first stage stretching at a temperature of usually 130 to 170°C and at a stretch ratio of usually 3.0 times and preferably 3.5 to 6 times. Successively, the thus biaxially stretched sheet is heat-treated at a temperature of 180 to 270°C under a tensed condition or under a relaxed condition within 30% to obtain a biaxially stretched film.

In the above stretching step, there may be adopted such a method in which the stretching in one of the directions is carried out in two or more stages. In this case, it is preferred that the final stretch ratios in the biaxial directions respectively lie within the above-specified ranges. In addition, there may also be used a simultaneous biaxial stretching method. The simultaneous biaxial stretching method is such a method in which the above unstretched sheet is simultaneously stretched in both of a machine direction and a transverse direction thereof under the temperature condition controlled to the range of usually 70 to 120°C and preferably 80 to 110°C. The stretch ratio used in the simultaneous biaxial stretching method is 4 to 50 times, preferably 7 to 35 times and more preferably 10 to 25 times in terms of an area ratio of the sheet. Successively, the thus biaxially stretched sheet is heat-treated at a temperature of 170 to 250°C under a tensed condition or under a relaxed condition within 30% to obtain a stretched and oriented film.

As a simultaneous biaxial stretching machine used in the above stretching method, there may be used conventionally known types of stretching machines such as a screw type, a pantograph type, a linear drive type, etc. The "screw type" means such a type in which a distance between clips fitted into a groove of a screw is spread, whereas the "pantograph type" means such a type in which a distance between the clips is spread using a pantograph. The "linear motor type" means such a type in which the clips can be independently controlled by using a linear motor principle, and has such an advantage that a distance between the clips can be optionally adjusted.

Further, the simultaneous biaxial stretching step may be divided into two or more stages. In this case, the stretching positions for the respective stages may be placed within one tenter, or a plurality of tenters may be used in combination.

In the present invention, the polyester film constituting the release film is preferably produced by using the simultaneous biaxial stretching method. The reason therefor is as follows. That is, in the conventional sequential biaxial stretching method, there tends to arise such a problem that as the area ratio is increased, the film suffers from defects such as breakage upon stretching. On the other hand, since the simultaneous biaxial stretching has a good stretching follow-up property, the area ratio of the film when stretched in a length direction and a transverse direction of the film can be further increased as compared to that of the sequential biaxial stretching, and further it is possible to produce a polyester film having a less unevenness of the thickness thereof.

In addition, during the above stretching step, the surface of the polyester film may be treated by a so-called coating/stretching (in-line coating) method. Such a coating treatment may be conducted, for example, after completion of the first stage stretching and before initiation of the second stage stretching, in particular, in the case of sequential biaxial stretching, although not particularly limited thereto.

The release film of the present invention is obtained by applying a coating material comprising a curing type silicone as a main component onto at least one surface of the polyester film. In the present invention, the release layer may be formed from the curing type silicone having a releasing property. The curing type silicone is such a silicone which undergoes an addition reaction between a vinyl group and a group having a silicon-hydrogen bond in a curing step thereof (so-called addition type silicone).

<u><Invention concerning the first aspect></u>

This invention is **characterized in that** the curing type silicone in the coating material comprises a vinyl group-containing polysiloxane chain in which a content of the vinyl group is not less than 3% in terms of siloxane units; and a ratio of SiH to vinyl (SiH/Vi) in the coating material is 2.5 to 7.

The silicone comprising a vinyl group-containing polysiloxane chain in which a content of the vinyl group is not less than 3% in terms of siloxane units means such a silicone in which the vinyl group-containing polysiloxane as a main component in the case of many of the addition type silicones comprises vinyl group-containing siloxane units in an amount of not less than 3% when calculated based on a siloxane unit forming a skeleton thereof (unit comprising one silicon atom which is generally represented by the following formula) as one unit.

$$R_nSiO_{(4-n)/2}$$

wherein n is an integer of 0 to 3; and R groups are each independently an optional group.

As an energy source for the curing treatment, there may be generally used a heat treatment or a combination of the heat treatment with ultraviolet irradiation or electron beam irradiation.

The molecular weight of the silicone compound used in the present invention is not particularly limited. In view of the coating in the form of a solution obtained by diluting the compound with a solvent, it is desirable that the silicone compound comprises at least one component which is in such a state as called "gum" by person having an ordinary skill in the art and has a viscosity of not less than about 1,000,000 mPa·s. In the practically used coating material, it is desirable that the silicone compound comprises at least one component which has a viscosity of not less than about 1000 mPa·s and preferably not less than 5000 mPa·s as measured in a 30% toluene solution. When the viscosity is too low, it may be difficult to select a solvent for achieving a uniform coating, or the resulting film tends to suffer from deteriorated coating surface properties such as cissing and tends to have disadvantages such as unsuitableness for optical films (refer to Kunio ITO, "Silicone Handbook", Nikkan-Kogyo-Shinbun-sha, p. 523 (1990)).

In the addition type silicone used in the present invention, not only the content of the vinyl group in the siloxane which is concerned with a crosslinking reaction thereof, but also the content ratio of the ≡SiH group to the vinyl group (SiH/Vi ratio) are important. In general, the ≡SiH group is used in an excessive amount. The SiH/Vi ratio in the silicone may be frequently adjusted to about 1.2 to about 2.0 (Masahiko OGAWA, "Convertech", p. 49 (1996)). In the silicone used in the present invention in which the content of the vinyl group in the vinyl group-containing polysiloxane chain thereof is not less than 3% in terms of siloxane units, the number of functional groups therein is absolutely large, so that the number of the ≡SiH groups which are present in an excessive amount becomes absolutely larger even if the same excessiveness percentage is used. Therefore, the excessiveness percentage of the ≡SiH group is usually reduced in many cases. However, the present inventors have found that when such a silicone is applied in the form of a thin film onto a polyester film, the SiH/Vi ratio is considerably deviated from the conventional preferred range. That is, in the present invention, the SiH/Vi ratio is 2.5 to 7 and preferably 3.0 to 5.0.

Examples of the diluting solvent used in the present invention include aromatic hydrocarbons such as toluene; aliphatic hydrocarbons such as hexane, heptane and isooctane; esters such as ethyl acetate and butyl acetate; ketones such as methyl ethyl ketone (MEK) and isobutyl methyl ketone; alcohols such as ethanol and 2-propanol; and ethers such as diisopropyl ether and dibutyl ether. These solvents may be used alone or in combination of any two or more thereof in view of a solubility, a coatability, a boiling point, etc.

In order to well control properties of the release layer, various additives such as a reaction controlling agent, an adhesion improving agent and a release controlling agent may be used in combination therein unless the addition thereof adversely affects the aimed effects of the present invention.

The coating amount (after dried) of the release layer on the polyester film is desirably smaller than the coating amount on papers owing to flatness of the polyester film, and is in the range of 0.01 to 1 g/m$^2$, preferably 0.04 to 0.5 g/m$^2$ and more preferably 0.06 to 0.3 g/m$^2$. When the coating amount of the release layer is too small, the resulting release film tends to be deteriorated in stability of a peel force thereof. On the other hand, when the coating amount of the release layer is too large, there tend to arise the risks such as promoted migration and blocking of the release layer.

In the present invention, as the method of forming the release layer on the polyester film, there may be used conventionally known coating methods such as a multi-roll coating method, a reverse gravure coating method, a direct gravure coating method, a bar coating method and a die coating method. These coating methods are described, for example, in Yuji HARAZAKI, "Coating Methods", Maki-shoten, 1979.

In addition, the polyester film constituting the release film of the present invention may be subjected to surface treatments such as corona treatment and plasma treatment. Further, the polyester film constituting the release film of the present invention may be previously provided thereon with a coating layer such as an adhesive layer and an antistatic layer.

<u>\<Invention concerning the second aspect\></u>

This invention is **characterized in that** the above coating material comprises, as main components, a solvent type silicone comprising a vinyl group-containing polysiloxane chain in which a content of the vinyl group is not less than 3% in terms of siloxane units, and a solvent-free type silicone having a viscosity of not more than 1000 mPa·s and comprising a vinyl group-containing polysiloxane chain in which a content of the vinyl group is not less than 3% in terms of siloxane units; and a ratio of SiH to Vi (SiH/Vi) in the coating material is 2.5 to 7.

The solvent-free type silicone means such a silicone having a viscosity capable of being coated without diluting it with a solvent, and has a smaller molecule and s shorter polysiloxane chain than those of the solvent-type silicone. For example, the above gum has a siloxane polymerization degree of from several thousands to several tens of thousands, whereas the solvent-free type silicone generally has a siloxane polymerization degree of from several tens to several hundreds. The vinyl group acting as a crosslinking reaction site in the addition type silicone may be usually bonded to a terminal end and an inside of the chain in many cases. The vinyl group bonded to a terminal end of the chain of the silicone is very rapidly reacted owing to a less steric hindrance thereof as compared to the vinyl group bonded to an inside of the chain. Therefore, the solvent-free type silicone which comprises a very large number of the terminal vinyl groups having a high reactivity as compared to the solvent-type silicone, has such an advantage that the curing velocity of a coating material formed therefrom becomes high. On the other hand, the solvent-free type silicone tends to be deteriorated in coatability when being coated on the polyester base material. In addition, the solvent-free type silicone tends to suffer from cissing due to its low viscosity, in particular, it may be very difficult to obtain a thin film having good surface properties therefrom when subjected to a thin film-coating step which is usually carried out upon production of a polyester release film.

In the invention concerning the second aspect, in order to utilize the above merits of the solvent-free type silicone and compensate the demerits thereof, the solvent-free type silicone is used in combination with the solvent type silicone having a high viscosity. The ratio between the combined silicones (solvent type/solvent-free type) in terms of solid contents thereof is 10/90 to 95/5 and preferably 40/60 to 90/10. The meanings of the solvent type silicone and the SiH/Vi ratio in the coating material as well as the other points (such as a diluting solvent) are the same as defined above.

<u>\<Invention concerning the third aspect\></u>

This invention is **characterized in that** the above coating material comprises, as main components, a solvent type silicone comprising a vinyl group-containing polysiloxane chain in which a content of the vinyl group is not less than 3% in terms of siloxane units, a solvent-free type silicone having a viscosity of not more than 1000 mPa·s and comprising a vinyl group-containing polysiloxane chain in which a content of the vinyl group is not less than 3% in terms of siloxane units, and a reactive heavy-release modifier; and a ratio of SiH to Vi (SiH/Vi) in the coating material is 2.5 to 7.

The reactive heavy-release modifier means a heavy-release modifier of such a type which is incorporated into the release layer by reacting with a siloxane polymer in the release coating material when the coating material is dried. The chemical structure of the reactive heavy-release modifier is not particularly limited unless it departs from the subject matter of the present invention. Examples of the preferred chemical structure of the reactive heavy-release modifier, include those having a vinyl group as a reactive group which are generally referred to as "MQ resins" and "MDQ resins". The ratio between the reactive heavy-release modifier and the components used in combination therewith may be optionally adjusted to attain a desired release property of the resulting release layer. The ratio therebetween (heavy-release modifier/(sum of solvent type and solvent-free type silicones)) in terms of solid contents thereof is 1/99 to 50/50 and preferably 2/98 to 30/70. When the ratio is too large, the resulting release layer tends to suffer from increased migration even though the reactive heavy-release modifier is used therein, and further it may be difficult to attain good surface properties of the obtained film because the reactive heavy-release modifier frequently has a low viscosity.

The meanings of the solvent type silicone and the solvent-free type silicone, the meanings of use of both the silicones and the ratio therebetween (1/99 to 50/50), and the meaning of the SiH/Vi ratio in the coating material (2.5 to 7) as well as the other points (such as a diluting solvent) are the same as defined above.

EXAMPLES

The present invention is described in more detail below by Examples. However, these Examples are only illustrative and not intended to limit the present invention thereto, and they are involved in the scope of the present invention unless the subject matters depart therefrom. Various properties used in the present invention were measured by the following methods.

(1) Measurement of peel force A (peel velocity: 0.3 m/min):

After attaching an adhesive tape ("No. 31B" produced by Nitto Denko Co., Ltd.) onto a releasing surface of a sample film, the resulting laminated film was cut into a size of 50 mm x 300 mm and allowed to stand at room temperature for 1 hr, and then subjected to measurement of a peel force thereof. The peel force was measured using "INTESCO MODEL 2001 TYPE" manufactured by Intesco Co., Ltd., by subjecting the film to 180° peel test at a pulling velocity of 0.3 (m/min).

(2) Measurement of peel force B (peel velocity: 30 m/min):

After attaching an adhesive tape ("No. 31B" produced by Nitto Denko Co., Ltd.) onto a releasing surface of a sample film, the resulting laminated film was cut into a size of 50 mm x 300 mm and allowed to stand at room temperature for 1 hr, and then subjected to measurement of a peel force thereof. The peel force was measured using a high-speed peel tester "TE-702 Model" manufactured by Tester Sangyo Co., Ltd., by subjecting the film to 180° peel test at a pulling velocity of 30 (m/min) in the following manner. That is, the sample film was fixed on the tester such that the releasing surface thereof faced upward, and the No. 31B adhesive tape attached thereto was peeled off from the film.

(3) Measurement of peel force C (peel force after being exposed to atmosphere):

A sample film was cut into an A4 size, and the cut film was suspended from a braid extending within a laboratory (non-clean environment) controlled at room temperature (23°C) and 50% RH for 24 hr. Then, after attaching an adhesive tape ("No. 502" produced by Nitto Denko Co., Ltd.; using a light color release paper side thereof) onto a releasing surface of the sample film, the resulting laminated film was cut into a size of 50 mm x 300 mm and allowed to stand at room temperature for 1 hr, and then subjected to measurement of a peel force thereof. The peel force was measured using "INTESCO MODEL 2001 TYPE" manufactured by Intesco Co., Ltd., by subjecting the film to 180° peel test at a pulling velocity of 0.3 (m/min).

(4) Measurement of peel force D (peel force without being exposed to atmosphere):

The same procedure for measurement of the peel force C was conducted except that the sample film was enclosed in a polyethylene bag and allowed to stand within the laboratory for 24 hr so as not to contact with outside air in place of suspending the film within the laboratory.

(5) Rate of adhesion for evaluating migration of release film:

A sample film was cut into an A4 size, and a 75 $\mu$m-thick biaxially stretched PET film ("DIAFOIL T100-75" produced by Mitsubishi Polyester Film Corporation) was overlapped on a releasing surface of the cut film. The resulting laminated film was pressed together at 60°C under a pressure of 1 MPa for 2 hr. The 75 $\mu$m-thick film pressed on the releasing surface of the cut film was used as a film for evaluating the migration. The 75 $\mu$m-thick biaxially stretched PET film (the same film as used above) was similarly pressed on an untreated PET film and used as a control film. Then, after attaching an adhesive tape ("No. 31B" produced by Nitto Denko Co., Ltd.) onto the thus pressed surface of each of the PET films, the resulting laminated films were cut into a size of 50 mm x 300 mm and allowed to stand at room temperature for 1 hr, and then subjected to measurement of a peel force thereof. The peel force was measured using "INTESCO MODEL 2001 TYPE" manufactured by Intesco Co., Ltd., by subjecting the films to 180° peel test at a pulling velocity of 0.3 (m/min).

```
Rate of adhesion for evaluation of migration (%) =

(peel force of the film for evaluation of migration)/(peel

force of the control film) x 100
```

In the film which suffered from large migration, a large amount of the silicone adhered onto films pressed thereonto, so that the peel force of the adhesive tape therefrom became smaller and the rate of adhesion for evaluation of migration (%) was also reduced. The rate of adhesion for evaluation of migration (%) is preferably not less than 90% and more preferably not less than 95%.

(6) Content of vinyl group of siloxane in coating material and ratio between contents of ≡SiH group and vinyl group (≡SiH/Vi ratio):

The content of vinyl group of siloxane in the coating material and the ratio between contents of ≡SiH group and vinyl group (≡SiH/Vi ratio) were calculated from the values obtain by subjecting the coating material solely or the mixture thereof to NMR analysis.

<Examples and Comparative Examples for the invention concerning the first aspect>

Example 1A:

A releasing agent having the following composition was applied onto a 38 $\mu$m-thick biaxially stretched PET film ("DIAFOIL T100-38" produced by Mitsubishi Polyester Film Corporation) such that a coating amount (after dried) of the releasing agent was 0.12 (g/m$^2$). The resulting coated film was heat-treated at 150°C for 10 sec to obtain a release film.

<<Composition of releasing agent>>

The following three components (i) to (iii) were diluted with a mixed solvent comprising toluene, MEK and isooctane (mixing ratio = 1:1:1) to prepare a coating solution having a solid concentration of 2% by weight.

(i) Solvent type silicone ("KS-830" produced by Shin-Etsu Chemical Co., Ltd.; non-volatile content: 30%); having a viscosity of 15000 mPa·s as measured in a 30% toluene solution and comprising a main polymer having a vinyl group content of about 5% in terms of siloxane units        100 parts by weight
(ii) Silicone represented by the formula: $(CH_3)_3SiO(-SiH(CH_3)-O)_m-Si(CH_3)_3$ ("HMS-991" produced by Gelest Inc.; viscosity: about 20 mPa·s)        2 parts by weight
(iii) Platinum-containing catalyst ("catPL-50T" produced by Shin-Etsu Chemical Co., Ltd.)        1 part by weight

Example 2A

The same procedure as defined in Example 1A was conducted except that the releasing agent was replaced with a releasing agent having the following composition, thereby obtaining a release film.

<<Composition of releasing agent>>

The following three components (i) to (iii) were diluted with a mixed solvent comprising toluene, MEK and isooctane (mixing ratio = 1:1:1) to prepare a coating solution having a solid concentration of 2% by weight.

(i) Solvent type silicone ("KS-830" produced by Shin-Etsu Chemical Co., Ltd.; non-volatile content: 30%); having a viscosity of 15000 mPa·s as measured in a 30% toluene solution and comprising a main polymer having a vinyl group content of about 5% in terms of siloxane units        100 parts by weight
(ii) Silicone represented by the formula: $(CH_3)_3SiO(-SiH(CH_3)-O)_m-Si(CH_3)_3$ ("HMS-991" produced by Gelest Inc.; viscosity: about 20 mPa·s)        1 part by weight
(iii) Platinum-containing catalyst ("catPL-50T" produced by Shin-Etsu Chemical Co., Ltd.)        1 part by weight

Example 3A

The same procedure as defined in Example 1A was conducted except that the releasing agent was replaced with a releasing agent having the following composition, thereby obtaining a release film.

<<Composition of releasing agent>>

The following three components (i) to (iii) were diluted with a mixed solvent comprising toluene, MEK and isooctane (mixing ratio = 1:1:1) to prepare a coating solution having a solid concentration of 2% by weight.

(i) Solvent type silicone ("KS-3601" produced by Shin-Etsu Chemical Co., Ltd.; non-volatile content: 30%); having a viscosity of 8000 mPa·s as measured in a 30% toluene solution and comprising a main polymer having a vinyl group content of about 8% in terms of siloxane units        100 parts by weight
(ii) Silicone represented by the formula: $(CH_3)_3SiO(-SiH(CH_3)-O)_m-Si(CH_3)_3$ ("HMS-991" produced by Gelest Inc.; viscosity: about 20 mPa·s)        3 parts by weight
(iii) Platinum-containing catalyst ("catPL-50T" produced by Shin-Etsu Chemical Co., Ltd.)        1 part by weight

Comparative Example 1A

The same procedure as defined in Example 1A was conducted except that the releasing agent was replaced with a releasing agent having the following composition, thereby obtaining a release film.

<<Composition of releasing agent>>

The following two components (i) and (ii) were diluted with a mixed solvent comprising toluene, MEK and isooctane (mixing ratio = 1:1:1) to prepare a coating solution having a solid concentration of 2% by weight.

(i) Solvent type silicone ("KS-3601" produced by Shin-Etsu Chemical Co., Ltd.; non-volatile content: 30%); having a viscosity of 8000 mPa·s as measured in a 30% toluene solution and comprising a main polymer having a vinyl group content of about 8% in terms of siloxane units        100 parts by weight
(ii) Platinum-containing catalyst ("catPL-50T" produced by Shin-Etsu Chemical Co., Ltd.)        1 part by weight

Comparative Example 2A

**[0062]** [0059] The same procedure as defined in Example 1A was conducted except that the releasing agent was replaced with a releasing agent having the following composition, thereby obtaining a release film.

<<Composition of releasing agent>>

The following three components (i) to (iii) were diluted with a mixed solvent comprising toluene, MEK and isooctane (mixing ratio = 1:1:1) to prepare a coating solution having a solid concentration of 2% by weight.

(i) Solvent type silicone ("KS-3703" produced by Shin-Etsu Chemical Co., Ltd.; non-volatile content: 30%); having a viscosity of 15000 mPa·s as measured in a 30% toluene solution and comprising a main polymer having a vinyl group content of about 1% in terms of siloxane unit        100 parts by weight
(ii) Silicone represented by the formula: $(CH_3)_3SiO(-SiH(CH_3)-O)_m-Si(CH_3)_3$ ("HMS-991" produced by Gelest Inc.; viscosity: about 20 mPa·s)        0.36 part by weight
(iii) Platinum-containing catalyst ("catPL-50T" produced by Shin-Etsu Chemical Co., Ltd.)        1 part by weight

Comparative Example 3A

The same procedure as defined in Example 1A was conducted except that the releasing agent was replaced with a releasing agent having the following composition, thereby obtaining a release film.

<<Composition of releasing agent>>

The following three components (i) to (iii) were diluted with a mixed solvent comprising toluene, MEK and isooctane (mixing ratio = 1:1:1) to prepare a coating solution having a solid concentration of 2% by weight.

(i) Solvent type silicone ("KS-774" produced by Shin-Etsu Chemical Co., Ltd.; non-volatile content: 30%); having a viscosity of 15000 mPa·s as measured in a 30% toluene solution and comprising a main polymer having a vinyl group content of about 0.8% in terms of siloxane units          90 parts by weight
(ii) Solvent type release modifier ("X-92-183" produced by Shin-Etsu Chemical Co., Ltd.; non-volatile content: 30%)          10 parts by weight
(iii) Platinum-containing catalyst ("catPL-50T" produced by Shin-Etsu Chemical Co., Ltd.)          1 part by weight

Comparative Example 4A

The same procedure as defined in Example 1A was conducted except that the releasing agent was replaced with a releasing agent having the following composition, thereby obtaining a release film.

<<Composition of releasing agent>>

The following three components (i) to (iii) were diluted with a mixed solvent comprising toluene, MEK and isooctane (mixing ratio = 1:1:1) to prepare a coating solution having a solid concentration of 2% by weight.

(i) Solvent type silicone ("KS-847H" produced by Shin-Etsu Chemical Co., Ltd.; non-volatile content: 30%); having a viscosity of 15000 mPa·s as measured in a 30% toluene solution and comprising a main polymer having a vinyl group content of about 0.4% in terms of siloxane units          85 parts by weight
(ii) Solvent type release modifier ("KS-3800" produced by Shin-Etsu Chemical Co., Ltd.; non-volatile content: 30%)          15 parts by weight
(iii) Platinum-containing catalyst ("catPL-50T" produced by Shin-Etsu Chemical Co., Ltd.)          1 part by weight

The properties of the respective films obtained in the above Examples and Comparative Examples are collectively shown in Table 1.

Table 1

| Examples and Comparative Examples | Peel force A (peel velocity: 0.3 m/min) [mN/cm] | Peel force B (peel velocity: 0.3 m/min) [mN/cm] | A/B | Peel force C after atmospheric exposure [mN/cm] |
|---|---|---|---|---|
| Example 1A | 25 | 61 | 0.41 | 30 |
| Example 2A | 30 | 66 | 0.45 | 45 |
| Example 3A | 28 | 59 | 0.47 | 33 |
| Comparative Example 1A | 23 | 69 | 0.33 | 1350 |
| Comparative Example 2A | 20 | 75 | 0.27 | 23 |
| Comparative Example 3A | 28 | 112 | 0.25 | 57 |
| Comparative Example 4A | 21 | 104 | 0.20 | 83 |

Table 1 (continued)

| Examples and Comparative Examples | Peel force D without atmospheric exposure [mN/cm] | C/D | SiH/Vi ratio of coating material | Rate of adhesion for evaluation of migration (%) |
|---|---|---|---|---|
| Example 1A | 30 | 1.0 | 4.7 | 99 |
| Example 2A | 32 | 1.4 | 3.8 | 98 |
| Example 3A | 32 | 1.0 | 3.7 | 99 |
| Comparative Example 1A | 22 | 61 | 2.1 | 99 |
| Comparative Example 2A | 19 | 1.2 | 6.3 | 99 |
| Comparative Example 3A | 29 | 2.0 | 3.3 | 87 |
| Comparative Example 4A | 22 | 3.8 | 1.6 | 96 |

The films obtained in Examples 1A to 3A were released with a relatively heavy peel force at a low peel velocity having a close relationship with a retention force upon storage, but released with a light peel force at a high peel velocity corresponding to a practical peel velocity upon use, and less influenced by atmospheric exposure and further exhibited an excellent anti-migration property. On the other hand, the release film obtained in Comparative Example 1A in which the ≡SiH/Vi ratio was small, failed to satisfy both of light peel force when released at a high peel velocity and relatively heavy peel force when released at a low peel velocity, and was considerably deteriorated in resistance to atmospheric exposure. The release film obtained in Comparative Example 2A in which the vinyl group content was small, exhibited a large difference between the peel force at a low peel velocity and the peel force at a high peel velocity even when the ≡SiH/Vi ratio was increased. In addition, the release films obtained in Comparative Examples 3A and 4A in which the peel force at a low peel velocity was controlled by using the release modifier, exhibited an excessively heavy peel force when released at a high peel velocity, and were also deteriorated in other properties.

<u><Examples for the invention concerning the second aspect></u>

<u>Example 1B:</u>

A releasing agent having the following composition was applied onto a 38 μm-thick biaxially stretched PET film ("DIAFOIL T100-38" produced by Mitsubishi Polyester Film Corporation) such that a coating amount (after dried) of the releasing agent was 0.12 (g/m$^2$). The resulting coated film was heat-treated at 150°C for 10 sec to obtain a release film.

<u><<Composition of releasing agent>></u>

The following four components (i) to (iv) were diluted with a mixed solvent comprising toluene, MEK and isooctane (mixing ratio = 1:1:1) to prepare a coating solution having a solid concentration of 2% by weight.

(i) Solvent type silicone ("KS-3601" produced by Shin-Etsu Chemical Co., Ltd.; non-volatile content: 30%); having a viscosity of 8000 mPa·s as measured in a 30% toluene solution and comprising a main polymer having a vinyl group content of about 8% in terms of siloxane units       67 parts by weight
(ii) Solvent-free type silicone ("KNS-3002" produced by Shin-Etsu Chemical Co., Ltd.; non-volatile content: 100%); having a viscosity of 300 mPa·s and comprising a main polymer having a vinyl group content of about 5% in terms of siloxane units       10 parts by weight
(iii) Silicone represented by the formula: $(CH_3)_3SiO(-SiH(CH_3)-O)_m-Si(CH_3)_3$ ("HMS-991" produced by Gelest Inc.; viscosity: about 20 mPa·s)       2.4 parts by weight
(iv) Platinum-containing catalyst ("catPL-50T" produced by Shin-Etsu Chemical Co., Ltd.)       1 part by weight

<u>Example 2B:</u>

The same procedure as defined in Example 1B was conducted except that the releasing agent was replaced with a releasing agent having the following composition, thereby obtaining a release film.

<u><<Composition of releasing agent>></u>

The following four components (i) to (iv) were diluted with a mixed solvent comprising toluene, MEK and isooctane (mixing ratio = 1:1:1) to prepare a coating solution having a solid concentration of 2% by weight.

(i) Solvent type silicone ("KS-830" produced by Shin-Etsu Chemical Co., Ltd.; non-volatile content: 30%); having a viscosity of 15000 mPa·s as measured in a 30% toluene solution and comprising a main polymer having a vinyl group content of about 5% in terms of siloxane units       67 parts by weight
(ii) Solvent-free type silicone ("KNS-3002" produced by Shin-Etsu Chemical Co., Ltd.; non-volatile content: 100%); having a viscosity of 300 mPa·s and comprising a main polymer having a vinyl group content of about 5% in terms of siloxane units 10 parts by weight
(iii) Silicone represented by the formula: $(CH_3)_3SiO(-SiH(CH_3)-O)_m-Si(CH_3)_3$ ("HMS-991" produced by Gelest Inc.; viscosity: about 20 mPa·s) 1.4 parts by weight
(iv) Platinum-containing catalyst ("catPL-50T" produced by Shin-Etsu Chemical Co., Ltd.) 1 part by weight

The properties of the respective films obtained in the above Examples are collectively shown in Table 2.

## Table 2

| Examples | Peel force A (peel velocity: 0.3 m/min) [mN/cm] | Peel force B (peel velocity: 0.3 m/min) [mN/cm] | A/B | Peel force C after atmospheric exposure [mN/cm] |
|---|---|---|---|---|
| Example 1B | 27 | 59 | 0.46 | 38 |
| Example 2B | 25 | 55 | 0.45 | 39 |

## Table 2 (continued)

| Examples | Peel force D without atmospheric exposure [mN/cm] | C/D | SiH/Vi ratio of coating material | Rate of adhesion for evaluation of migration (%) |
|---|---|---|---|---|
| Example 1B | 34 | 1.1 | 3.5 | 101 |
| Example 2B | 30 | 1.3 | 4.6 | 101 |

The films obtained in Examples 1B and 2B were released with a relatively heavy peel force at a low peel velocity having a close relationship with a retention force upon storage, but released with a light peel force at a high peel velocity corresponding to a practical peel velocity upon use, and less influenced by atmospheric exposure and further exhibited an excellent anti-migration property.

<Examples for the invention concerning the third aspect>

Example 1C:

A releasing agent having the following composition was applied onto a 38 $\mu$m-thick biaxially stretched PET film ("DIAFOIL T100-38" produced by Mitsubishi Polyester Film Corporation) such that a coating amount (after dried) of the releasing agent was 0.12 (g/m$^2$). The resulting coated film was heat-treated at 150°C for 10 sec to obtain a release film.

<<Composition of releasing agent>>

The following four components (i) to (iv) were diluted with a mixed solvent comprising toluene, MEK and isooctane (mixing ratio = 1:1:1) to prepare a coating solution having a solid concentration of 2% by weight.

(i) Solvent type silicone ("KS-3601" produced by Shin-Etsu Chemical Co., Ltd.; non-volatile content: 30%); having a viscosity of 8000 mPa·s as measured in a 30% toluene solution and comprising a main polymer having a vinyl group content of about 8% in terms of siloxane units        70 parts by weight
(ii) Solvent-free type silicone ("KNS-3002" produced by Shin-Etsu Chemical Co., Ltd.; non-volatile content: 100%); having a viscosity of 300 mPa·s and comprising a main polymer having a vinyl group content of about 5% in terms of siloxane units        4.5 parts by weight
·Solvent type reactive release modifier ("KS-3800" produced by Shin-Etsu Chemical Co., Ltd.; non-volatile content: 30%)        15 parts by weight
(iii) Silicone represented by the formula: $(CH_3)_3SiO(-SiH(CH3)-O)_m-Si(CH_3)_3$ ("HMS-991" produced by Gelest Inc.; viscosity: about 20 mPa·s)        2.4 parts by weight
(iv) Platinum-containing catalyst ("catPL-50T" produced by Shin-Etsu Chemical Co., Ltd.)        1 part by weight

Example 2C:

The same procedure as defined in Example 1C was conducted except that the releasing agent was replaced with a releasing agent having the following composition, thereby obtaining a release film.

<<Composition of releasing agent>>

The following four components (i) to (iv) were diluted with a mixed solvent comprising toluene, MEK and isooctane (mixing ratio = 1:1:1) to prepare a coating solution having a solid concentration of 2% by weight.

(i) Solvent type silicone ("KS-3601" produced by Shin-Etsu Chemical Co., Ltd.; non-volatile content: 30%); having a viscosity of 8000 mPa·s as measured in a 30% toluene solution and comprising a main polymer having a vinyl group content of about 8% in terms of siloxane units          70 parts by weight

·Solvent-free type silicone ("KNS-3002" produced by Shin-Etsu Chemical Co., Ltd.; non-volatile content: 100%); having a viscosity of 300 mPa·s and comprising a main polymer having a vinyl group content of about 5% in terms of siloxane units          7.5 parts by weight

(ii) Solvent type reactive release modifier ("KS-3800" produced by Shin-Etsu Chemical Co., Ltd.; non-volatile content: 30%)          5 parts by weight

(iii) Silicone represented by the formula: $(CH_3)_3SiO(-SiH(CH_3)-O)_m-Si(CH_3)_3$ ("HMS-991" produced by Gelest Inc.; viscosity: about 20 mPa·s)          2.4 parts by weight

(iv) Platinum-containing catalyst ("catPL-50T" produced by Shin-Etsu Chemical Co., Ltd.)          1 part by weight

The properties of the respective films obtained in the above Examples are collectively shown in Table 3.

## Table 3

| Examples | Peel force A (peel velocity: 0.3 m/min) [mN/cm] | Peel force B (peel velocity: 0.3 m/min) [mN/cm] | A/B | Peel force C after atmospheric exposure [mN/cm] |
|---|---|---|---|---|
| Example 1C | 56 | 98 | 0.57 | 57 |
| Example 2C | 37 | 76 | 0.49 | 40 |

## Table 3 (continued)

| Examples | Peel force D without atmospheric exposure [mN/cm] | C/D | SiH/Vi ratio of coating material | Rate of adhesion for evaluation of migration (%) |
|---|---|---|---|---|
| Example 1C | 57 | 1.0 | 3.3 | 98 |
| Example 2C | 40 | 1.0 | 3.4 | 99 |

The films obtained in Examples 1C and 2C were released with a relatively heavy peel force at a low peel velocity having a close relationship with a retention force upon storage, but released with a light peel force at a high peel velocity corresponding to a practical peel velocity upon use, and less influenced by atmospheric exposure and further exhibited an excellent anti-migration property.

## Claims

1. A release film comprising a polyester film and a coating material applied onto at least one surface of the polyester film which comprises a curing type silicone as a main component,
the curing type silicone in the coating material comprising a vinyl group-containing polysiloxane chain in which a content of the vinyl group is not less than 3% in terms of siloxane units; and
a ratio of SiH to Vi (SiH/Vi) in the coating material being 2.5 to 7.

2. A release film comprising a polyester film and a coating material applied onto at least one surface of the polyester film which comprises a curing type silicone as a main component,

the coating material comprising, as main components, a solvent type silicone comprising a vinyl group-containing polysiloxane chain in which a content of the vinyl group is not less than 3% in terms of siloxane units, and a solvent-free type silicone having a viscosity of not more than 1000 mPa·s and comprising a vinyl group-containing polysiloxane chain in which a content of the vinyl group is not less than 3% in terms of siloxane units; and

a ratio of SiH to Vi (SiH/Vi) in the coating material being 2.5 to 7.

3. A release film comprising a polyester film and a coating material applied onto at least one surface of the polyester film which comprises a curing type silicone as a main component,
the coating material comprising, as main components, a solvent type silicone comprising a vinyl group-containing polysiloxane chain in which a content of the vinyl group is not less than 3% in terms of siloxane units, a solvent-free type silicone having a viscosity of not more than 1000 mPa·s and comprising a vinyl group-containing polysiloxane chain in which a content of the vinyl group is not less than 3% in terms of siloxane units, and a reactive heavy-release modifier; and
a ratio of SiH to Vi (SiH/Vi) in the coating material being 2.5 to 7.

## INTERNATIONAL SEARCH REPORT

| | International application No. |
|---|---|
| | PCT/JP2009/000845 |

A. CLASSIFICATION OF SUBJECT MATTER
*B32B27/00*(2006.01)i, *G02B5/30*(2006.01)i

According to International Patent Classification (IPC) or to both national classification and IPC

B. FIELDS SEARCHED

Minimum documentation searched (classification system followed by classification symbols)
B32B1/00-43/00, C08L83/07, G02B5/30

Documentation searched other than minimum documentation to the extent that such documents are included in the fields searched

| Jitsuyo Shinan Koho | 1922-1996 | Jitsuyo Shinan Toroku Koho | 1996-2009 |
|---|---|---|---|
| Kokai Jitsuyo Shinan Koho | 1971-2009 | Toroku Jitsuyo Shinan Koho | 1994-2009 |

Electronic data base consulted during the international search (name of data base and, where practicable, search terms used)
WPI

C. DOCUMENTS CONSIDERED TO BE RELEVANT

| Category* | Citation of document, with indication, where appropriate, of the relevant passages | Relevant to claim No. |
|---|---|---|
| Y | JP 6-93183 A (Shin-Etsu Chemical Co., Ltd.), 05 April, 1994 (05.04.94), Claims; Par. Nos. [0001], [0011], [0018] (Family: none) | 1-3 |
| Y | JP 62-240363 A (Shin-Etsu Chemical Co., Ltd.), 21 October, 1987 (21.10.87), Claims; page 4, lower left column & KR 10-1995-0000998 B1 | 1-3 |
| Y | JP 2000-169794 A (Tokuyama Corp.), 20 June, 2000 (20.06.00), Claims; Par. No. [0001] (Family: none) | 2,3 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 28 April, 2009 (28.04.09) | 19 May, 2009 (19.05.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
|---|
| PCT/JP2009/000845 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 11-61094 A (Oji Paper Co., Ltd.), 05 March, 1999 (05.03.99), Claims (Family: none) | 3 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001290141 A
- JP 2001047580 A
- JP 59005216 A
- JP 59217755 A